# DEMANDE DE BREVET EUROPEEN

(11) **EP 1 085 799 A1**
(43) Date de publication de la demande: **21.03.2001**
(21) Numéro de dépôt: 00402524.3
(22) Date de dépôt: 13.09.2000
(51) Int. Cl.: H05K 9/00

(54) **Dispositif de protection de composants électroniques**

(30) Priorité: 14.09.1999 FR 9911473
(71) Demandeur: SAGEM SA, 75116 Paris (FR)
(72) Inventeur: Charton, Olivier, 75012 Paris (FR); Roger, Christian, 75005 Paris (FR)
(74) Mandataire: Fruchard, Guy

(57) **Abrégé**

Dispositif de protection de composants électroniques (1) porté par une plaque support (2), le dispositif comportant au moins un capot de blindage individuel (3) relié à une masse de la plaque support et recouvrant au moins un composant électronique (1), le capot de blindage individuel comprenant au moins une paroi latérale conductrice (13), caractérisé en ce qu'un tampon élastique (10) entouré d'une couche conductrice flexible est maintenu appliqué sur le capot de blindage individuel (3) par un boîtier externe (4)

## Description

La présente invention concerne un dispositif de protection de composants électroniques.

On sait que certains composants électroniques, notamment les oscillateurs destinés à générer les fréquences porteuses pour la transmission de signaux de radiocommunication, sont très sensibles aux perturbations électromagnétiques ainsi qu'aux chocs ou aux vibrations qui modifient leurs performances. Afin de lutter contre ces perturbations, on associe à ces composants des filtres électroniques ainsi que des dispositifs d'asservissement en phase. Toutefois, compte tenu de l'augmentation des exigences en matière de performances ces dispositifs s'avèrent insuffisants et pour protéger les composants électroniques contre les perturbations, on réalise un dispositif de protection à double blindage c'est-à-dire un dispositif comportant un capot de blindage individuel recouvrant les composants électroniques les plus sensibles et un capot de blindage général recouvrant plusieurs capots de blindage individuels ainsi que des composants électroniques moins sensibles, les capots de blindage étant reliés à un circuit de masse commun.

En dépit de ces précautions, on a constaté la persistance de certaines perturbations et l'on pense que ces perturbations résultent d'une part de la mise en vibration du capot individuel sous l'effet de vibrations extérieures et des différences de potentiel engendrées au sein du capot de blindage individuel en raison de l'impédance de celui-ci aux fréquences de fonctionnement des composants électroniques.

Selon l'invention, on propose un dispositif de protection de composants électroniques portés par une plaque support, le dispositif comportant au moins un capot de blindage individuel relié à une masse de la plaque support et recouvrant au moins un composant électronique, le capot de blindage individuel comprenant au moins une paroi latérale conductrice, caractérisé en ce qu'un tampon élastique entouré d'une couche conductrice flexible est maintenu appliqué sur le capot de blindage individuel par un boîtier externe.

Selon une version avantageuse de l'invention, le boîtier externe est conducteur et forme un capot de blindage général recouvrant au moins un capot de blindage individuel, les capots de blindage étant reliés à un circuit de masse commun porté par la plaque support.

Ainsi, l'élasticité du tampon assure un amortissement des vibrations tandis que la liaison électrique qui est assurée par la couche externe conductrice entre le capot de blindage individuel et le boîtier externe, assure une diminution de l'impédance du capot de blindage individuel de sorte que le fonctionnement des composants électroniques est amélioré.

Par ailleurs, le capot de blindage individuel est généralement réalisé sous forme d'un boîtier qui recouvre les composants électroniques à protéger. En raison de ce recouvrement il est nécessaire de mettre en place le capot individuel après avoir fixé les composants électroniques sur le support sur lequel ils sont montés, généralement une plaque portant un circuit imprimé. La réalisation des dispositifs actuels implique donc plusieurs opérations successives qui augmentent les coûts de fabrication.

Selon un second aspect de l'invention le capot de blindage individuel comporte une paroi latérale ayant un bord libre et le tampon élastique recouvre le bord libre de la paroi latérale.

Il est ainsi possible de fixer la paroi latérale du capot individuel par des opérations automatisées effectuées simultanément au montage des composants électroniques, et lors de la mise en place du capot de blindage général, la couche externe conductrice du tampon élastique prend appui sur le bord de la paroi latérale et réalise une enceinte blindée équivalente au capot individuel antérieur.

D'autres caractéristiques et avantages de l'invention apparaîtront à la lecture de la description qui suit de deux modes de réalisation particuliers non limitatifs de l'invention, en référence aux figures ci-jointes parmi lesquelles :
- la figure 1 est une vue en coupe schématique d'un premier mode de réalisation du dispositif selon l'invention,
- la figure 2 est une vue en coupe analogue à celle de la figure 1 d'un second mode de réalisation de l'invention.

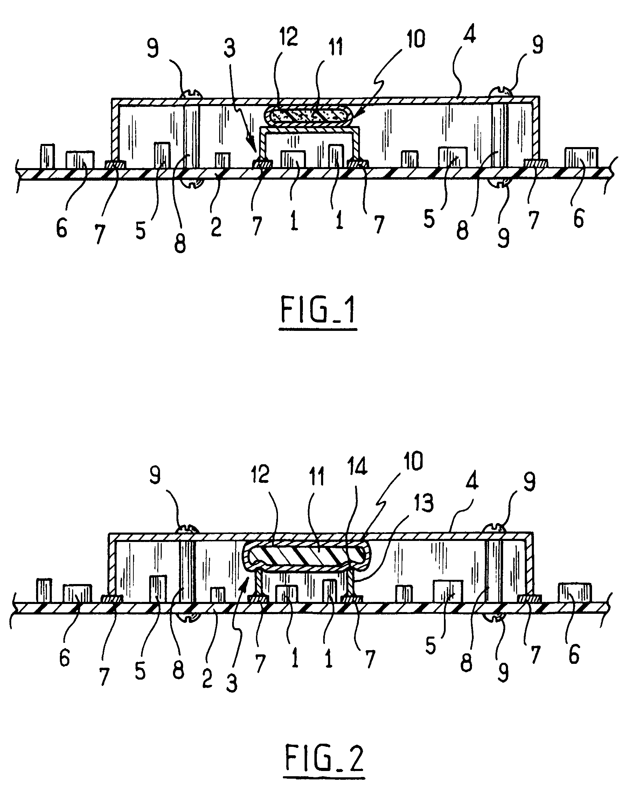

En référence à la figure 1, le dispositif selon l'invention est destiné à assurer la protection de composants électroniques 1 portés par une plaque support, ici une plaque de circuit imprimé 2.

De façon connue en soi le dispositif de protection comporte un capot de blindage individuel conducteur 3 recouvrant les composants électroniques les plus sensibles et un capot de blindage général 4 recouvrant le capot de blindage individuel 3 ainsi que des composants électroniques moins sensibles 5, des composants électroniques 6 ne nécessitant pas de blindage étant par ailleurs montés sur la plaque de circuit imprimé 2.

Le capot de blindage individuel 3 et le capot de blindage général 4 sont reliés à un circuit de masse commun 7 réalisé sur la plaque de circuit imprimé. Le capot de blindage individuel 3 est de préférence soudé au circuit de masse 7 tandis que le capot de blindage général 4 est maintenu en place par des colonnettes 8 auxquelles sont associées des vis de fixation 9.

Selon l'invention le dispositif de protection comporte en outre un tampon élastique 10 qui est pincé entre le capot de blindage individuel 3 et le capot de blindage général 4. Le tampon élastique 10 comporte de préférence une âme en mousse isolante 11, par exemple une mousse de polyuréthane entourée d'une couche flexible conductrice 12, par exemple un tissu conducteur chargé à l'argent, au cuivre ou au nickel-cuivre. Le tampon élastique 10 est par exemple un segment d'un cordon de mousse élastique enveloppée d'un tissu conducteur ou d'une feuille conductrice souple. Pour faciliter le montage ainsi que les interventions ultérieures, le tampon élastique 10 est de préférence fixé à l'intérieur du capot de blindage général 4 par un point de colle.

La figure 2 illustre un second mode de réalisation de l'invention dans lequel les composants identiques au premier mode de réalisation portent les mêmes références numériques. Ce second mode de réalisation se distingue du premier mode de réalisation par le fait que le capot de blindage 3 comporte seulement une paroi latérale conductrice 13 et par le fait que le tampon élastique 10 recouvre le bord libre 14 de la paroi latérale 13 et prend appui sur celui-ci pour former un capot de blindage individuel complet autour des composants électroniques 1 tout en assurant la liaison avec le capot de blindage général.

Bien entendu, l'invention n'est pas limitée aux modes de réalisation décrits et est susceptible de variantes qui apparaîtront à l'homme de métier sans sortir du cadre de l'invention tel que décrit par les revendications.

En particulier, bien que l'invention ait été illustrée en relation avec des modes de réalisation comportant un seul capot individuel, l'invention peut être mise en oeuvre en relation avec un circuit électronique comportant plusieurs séries de composants électroniques 1 chacune protégée par un capot individuel, un tampon élastique 10 étant pincé entre chaque capot individuel et un capot général commun.

On remarquera également que le second aspect de l'invention peut mis en oeuvre pour réaliser un capot de blindage unique lorsque les composants électroniques ne nécessitent pas un double blindage. Dans ce cas le tampon élastique 10 peut être associé à un boîtier externe isolant qui a pour fonction de maintenir le tampon élastique 10 en appui sur le bord de la paroi latérale 13 afin de réaliser une enceinte conductrice fermée autour des composants électroniques à protéger.

## Revendications

1. Dispositif de protection de composants électroniques (1) porté par une plaque support (2), le dispositif comportant au moins un capot de blindage individuel (3) relié à une masse de la plaque support et recouvrant au moins un composant électronique (1), le capot de blindage individuel comprenant au moins une paroi latérale conductrice (13), caractérisé en ce qu'un tampon élastique (10) entouré d'une couche conductrice flexible est maintenu appliqué sur le capot de blindage individuel (3) par un boîtier externe (4).

2. Dispositif selon la revendication 1, caractérisé en ce que le boîtier externe (4) est conducteur et forme un capot de blindage général (4) recouvrant au moins un capot de blindage individuel (3), les capots de blindage étant reliés à un circuit de masse commun (7) porté par la plaque support (2).

3. Dispositif selon la revendication 1 ou la revendication 2, caractérisé en ce que la paroi latérale du capot individuel (3) comporte un bord libre (14) et en ce que le tampon élastique (10) recouvre le bord libre (14) de la paroi latérale (13).
